Europäisches Patentamt

European Patent Office

Office européen des brevets

(19)

(11) Publication number: **0 107 340 B1**

(12)

# EUROPEAN PATENT SPECIFICATION

(45) Date of publication of patent specification: **22.07.92**  (51) Int. Cl.⁵: **G11C 11/24**

(21) Application number: **83305536.1**

(22) Date of filing: **20.09.83**

(54) **Dual port type semiconductor memory.**

(30) Priority: **30.09.82 JP 169551/82**

(43) Date of publication of application:
**02.05.84 Bulletin 84/18**

(45) Publication of the grant of the patent:
**22.07.92 Bulletin 92/30**

(84) Designated Contracting States:
**DE FR GB**

(56) References cited:
**EP-A- 0 024 874**
**US-A- 3 968 480**
**US-A- 4 044 340**
**US-A- 4 086 662**

**IBM TECHNICAL DISCLOSURE BULLETIN, vol. 18, no. 6, November 1975, pages 1849-1850, New York, US; J.C. HSIEH: "Read and write for random-access memory array"**

(73) Proprietor: **FUJITSU LIMITED**
**1015, Kamikodanaka Nakahara-ku**
**Kawasaki-shi Kanagawa 211(JP)**

(72) Inventor: **Baba, Fumio Miyamaedaira Gurin Haitsu 48-303**
**430 Mukogaoka Miyamae-ku**
**Kawasaki-shi Kanagawa 213(JP)**

(74) Representative: **Skone James, Robert Edmund et al**
**GILL JENNINGS & EVERY 53-64 Chancery Lane**
**London WC2A 1HN(GB)**

## Description

The present invention relates to a semiconductor memory, more particularly, to a dual port type semiconductor memory particularly for use in a memory of a computer system.

Recent research and development in the field of semiconductor memories has concentrated on the achievement of greater miniaturisation and integration. Few studies, however, have been made on the achievement of greater efficiency of utilisation of semiconductor memories.

One well-known technique for achieving greater efficiency of utilisation of semiconductor memories is the use of a dual port type semiconductor memory using a static type RAM.

A static type RAM has the feature of "non-destructive read out". That is to say, even if data is read out from a memory cell, the data stored in the memory cell is not erased. Since the static type RAM has the feature as mentioned above, it is possible simultaneously to read out two data from the same memory cell.

A static type RAM, however, has many elements compared with a dynamic type RAM, usually six as opposed to two. Therefore, a static type RAM is disadvantageous in minimising and increasing the integration of memories.

US-A-4044340 illustrates a single port memory having a read/write means to enable data to be written to and read from the memory. It provides no means, however, to enable anything other than the single read/write operation to be performed at any one time.

In accordance with the present invention, a semiconductor memory includes a dynamic type random access memory comprising a plurality of word lines; a plurality of pairs of bit lines; a plurality of dynamic memory cells each cell being connected between respective word lines and bit lines at each intersection of the word lines and the pairs of bit lines respectively; a plurality of first column decoders each connected to a common writing-reading out bus, and to a respective pair of bit lines, wherein each of the first column decoders is connected to the writing-reading out bus through a pair of gates comprising two transistors connected to the respective bit lines to enable data to be transfered either from the bit lines to the writing-reading out bus or from the writing-reading out bus to the bit lines; and a plurality of sense amplifiers each connected to a respective pair of bit lines to store temporarily data in a selected memory cell to prevent destruction of the data during a reading operation; and is characterised in that the memory comprises a dual port memory, the memory further comprising a plurality of second column decoders each connected to a common reading out bus, and to a respective pair of bit lines, wherein each of the second column decoders is connected to the reading out bus through a pair of gates comprising four transistors, gate electrodes of two of the four transistors being connected to the bit lines and the other two of the four transistors being connected to the reading out bus to enable data to be transferred only from the bit lines to the reading out bus.

Up to now no dual port type semiconductor memory of this type using a dynamic type RAM has been realised. The invention provides a dual port type semiconductor memory including a dynamic type RAM enabling a high efficiency of utilisation. It also provides a dual port type semiconductor memory featuring high miniaturisation and integration.

Thus, it is possible to use a dynamic type RAM as dual port type semiconductor memory, which is advantageous to minimise and to increase the integration of the dual port type semiconductor memory.

An example of a dual port type memory in accordance with the present invention will now be described and contrasted with a known memory with reference to the accompanying drawings, in which:-

Figure 1 is a basic circuit diagram of a portion of a conventional dual port type conductor memory using a static type RAM;

Fig. 2 is a basic circuit diagram of a portion of a dual port type semiconductor memory using a dynamic type RAM according to an embodiment of the present invention; and,

Fig. 3 is a block diagram of the overall structure of a dual port type semiconductor memory using a dynamic type RAM according to an embodiment of the present invention.

Before describing the preferred embodiments, an explanation will be given of a conventional dual port type semiconductor memory using a static type RAM for reference.

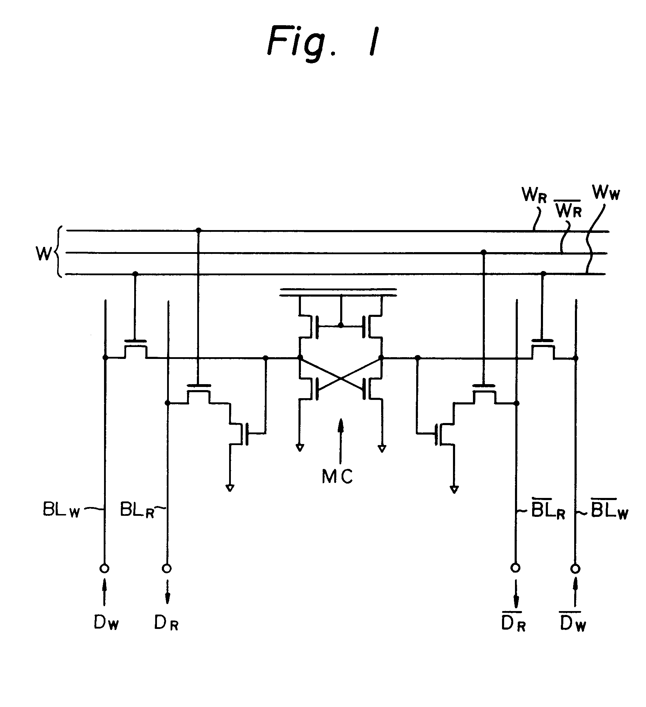

Referring to Fig. 1, MC represents a memory cell formed by a static type RAM in the form of a flip-flop circuit. The memory cell MC is connected between word lines W, consisting of lines $W_R$, $\overline{W_R}$, and $W_W$, and two pairs of bit lines $BL_W$, $BL_R$ and $\overline{BL_R}$, $\overline{BL_W}$ at each intersection of these word lines and bit lines.

In writing to the memory cell MC, the word line $W_W$ and the bit lines $BL_W$, $\overline{BL_W}$ are selected and writing data $D_W$, $\overline{D_W}$ are applied to the memory cell MC by commands transmitted from a central processing unit (CPU, not shown).

In reading out from the memory cell MC, the word line $W_R$ and the bit line $BL_R$ are selected and the read-out data $D_R$ is obtained from the memory cell MC by commands transmitted from the CPU through an address line (not shown).

If the memory cell MC is accessed during the above-mentioned reading out process by commands transmitted from the CPU through another address line (not shown), the word line $\overline{W_R}$ and the bit line $\overline{BL_R}$ are selected and inverted reading out data $\overline{D_R}$ is obtained from the memory cell MC. The dual port type semiconductor memory using the static type RAM can be accessed simultaneously by means of the above-mentoned writing and reading out process. As a result, the efficiency of utilization for the semiconductor memory is increased.

A dual port type semiconductor memory using a dynamic type RAM according to an embodiment of the present invention will now be described.

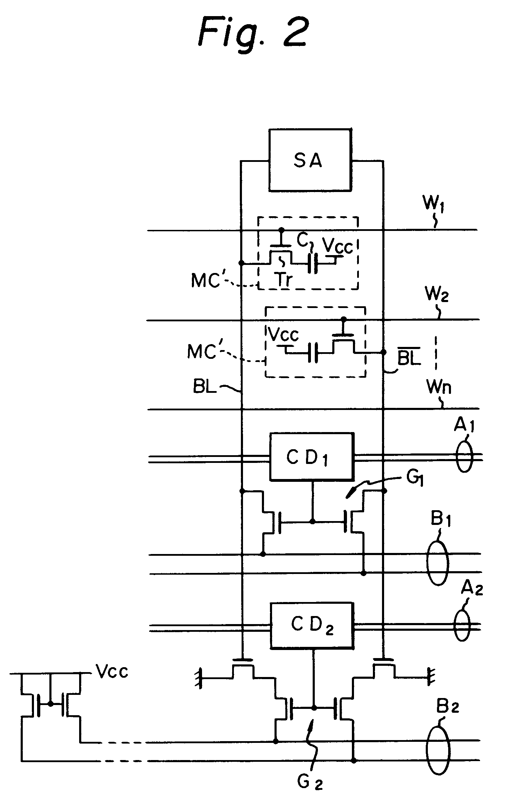

Referring to Fig. 2, a plurality of word lines are shown by the reference letters $W_1$, $W_2$ --- $W_n$. A pair of bit lines is shown by the reference letters BL and $\overline{BL}$. A plurality of single transistor type dynamic memory cells are shown by the same reference letters MC'. Each of the memory cells MC' is connected between a word line and bit line at each intersection of the word lines and bit lines, as shown in the drawing. Each of the memory cells MC' consists of a transistor Tr, a capacitor C, and voltage source $V_{CC}$.

To use the capacitor C to store data, the data is rewritten periodically to prevent it from being extinguished by unavoidable discharge in what is generally called a "refresh" operation. The refresh operation can be performed by a sense amplifier SA. The sense amplifier SA usually comprises a flip-flop circuit and can apply the refreshed data as before to the memory cell MC' before the data stored in the capacitor C of the memory cell MC' is extinguished. Accordingly, the sense amplifier SA can store data for a short term. Therefore, the sense amplifier SA has the function of "non-destructive read out" as well as the feature of the static type RAM as mentioned above. Moreover, the sense amplifier SA can function to hold the data to all memory cells MC' connected to the sense amplifier SA in the case of both writing and reading of the data.

The dual port type semiconductor memory using a dynamic type RAM according to the present invention, moreover, comprises at least two column decoders ($CD_1$, $CD_2$). A first column decoder $CD_1$ is connected to the writing-reading out bus $B_1$ through a pair of gates $G_1$. A second column decoder $CD_2$ is connected to the reading out bus $B_2$ through a pair of gates $G_2$. Assuming that the CPU requests simultaneously read out of the data D from the upper memory cell MC' and the data D' from the lower memory cell MC' through different address routes (not shown), the first column decoder $CD_1$ is selected through a column address bus $A_1$ for one address route, and the second

column decoder $CD_2$ is selected through a column address bus $A_2$ for the other address route.

Consequently, the desired data is applied to the CPU through each of the address routes.

The first column decoder $CD_1$ can write the data to the memory cell MC' because a pair of gates $G_1$ is directly connected between the bit lines BL, $\overline{BL}$ and the writing-reading out bus $B_1$ not through a gate of the transistor. Accordingly, the writing access can be performed only through the first column decoder $CD_1$.

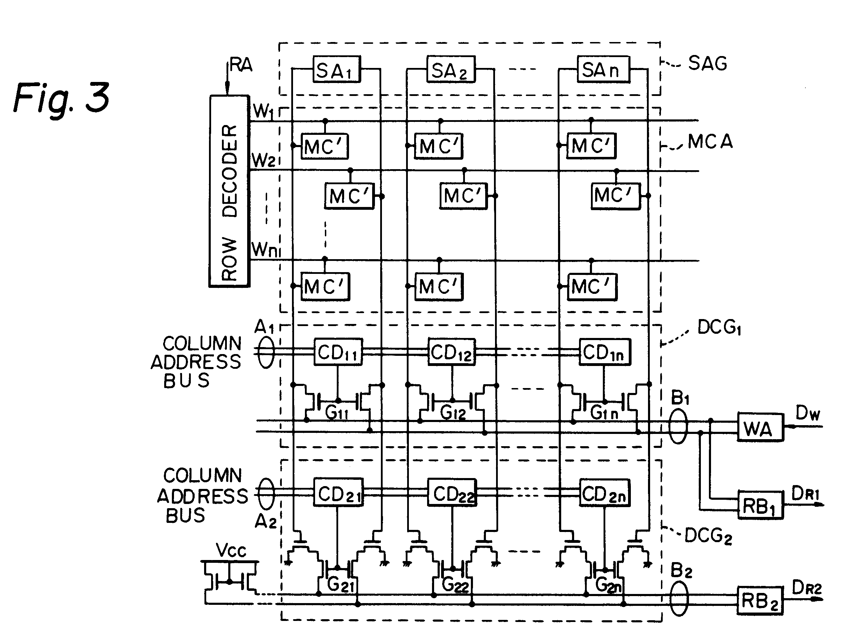

When the data is written to one of the memory cells MC' at the optional word line $W_n$, at the same time, if the CPU requests to read out data from another memory cell MC' (not shown), selection of the memory cell and reading out of the data from it can be performed by another column decoder (not shown). Since a pair of gates $G_2$ is controlled by the second column decoder $CD_2$ and is connected to the bit lines BL, $\overline{BL}$ through a gate of the transistor, the data on the bit lines are not affected by the action of the pair of gates $G_2$. Namely, when the data is read out from the memory cell through a pair of gates $G_2$, the data on the bit lines are not destroyed due to the influence of the reading out bus $B_2$. Meanwhile, since a pair of gates $G_1$ is controlled by the first column decoder $CD_1$ and is directly connected to the bit lines BL, $\overline{BL}$ through a drain and a source of the transistor not through the gate as mentioned above, the data on the bit lines are affected by the writing-reading out bus $B_1$. In order to prevent the influence from bus $B_1$, when the data is read out from the memory cell through the first column decoder $CD_1$, the memory cell is refreshed by an external amplifier (WA, shown in Fig. 3) connected to the bus $B_1$ as well as by the conventional external amplifier at the dynamic type RAM.

Figure 3 is a block diagram of the overall structure of a dual port type semiconductor memory using a dynamic type RAM. Referring to Fig. 3, reference SAG shows a group of the sense amplifiers ($SA_1$ to $SA_n$), and MCA shows a group of the memory cells MC', i.e., a memory cell array. Reference letter $DCG_1$ shows a group of first column decoders $CD_{11}$-$CD_{1n}$ including pairs of gates ($G_1$ to $G_{1n}$), and $DCG_2$ shows a group of second column decoders $CD_{21}$-$CD_{2n}$ including pairs of gates ($G_{21}$ to $G_{2n}$). A row decoder can select one of the word lines ($W_1$, $W_2$ --- $W_n$) based on a row address commnnd RA transmitted from the CPU. One of the first column decoders ($CD_{11}$ to $CD_{1n}$) in the $DCG_1$ is selected by a column address command transmitted from the CPU through a column address bus $A_1$. Similarly, the second column decoder ($CD_{21}$ to $CD_{2n}$) in the $DCG_2$ is selected through a column address bus $A_2$. The read out data from the $DCG_1$ is applied to a first reading out

buffer amplifier RB$_1$ through the bus B$_1$. The read out data D$_{R1}$ is obtained from the output of the buffer RB$_1$. Since the first column decoder has the function of writing as mentioned above, the writing data D$_W$ is applied to the bus B$_1$ through a writing amplifier WA. Meanwhile, the read out data from the DCG$_2$ is applied to a second reading out buffer amplifier RB$_2$ through the bus B$_2$. The read out data D$_{R2}$ is obtained from the output of the buffer RB$_2$.

## Claims

1. A semiconductor memory including a dynamic type random access memory (RAM) comprising a plurality of word lines (W$_1$ ... W$_n$); a plurality of pairs of bit lines (BL, $\overline{BL}$); a plurality of dynamic memory cells (MC') each cell being connected between respective word lines and bit lines at each intersection of the word lines and the pairs of bit lines respectively; a plurality of first column decoders (CD$_1$) each connected to a common writing-reading out bus (B$_1$), and to a respective pair of bit lines, wherein each of the first column decoders (CD$_1$) is connected to the writing-reading out bus (B$_1$) through a pair of gates (G$_1$) comprising two transistors connected to the respective bit lines to enable data to be transfered either from the bit lines to the writing-reading out bus (B$_1$) or from the writing-reading out bus (B$_1$) to the bit lines; and a plurality of sense amplifiers (SA) each connected to a respective pair of bit lines to store temporarily data in a selected memory cell to prevent destruction of the data during a reading operation; characterised in that the memory comprises a dual port memory, the memory further comprising a plurality of second column decoders (CD$_2$) each connected to a common reading out bus (B$_2$), and to a respective pair of bit lines, wherein each of the second column decoders (CD$_2$) is connected to the reading out bus (B$_2$) through a pair of gates (G$_2$) comprising four transistors, gate electrodes of two of the four transistors being connected to the bit lines and the other two of the four transistors being connected to the reading out bus (B$_2$) to enable data to be transferred only from the bit lines to the reading out bus (B$_2$).

2. A dual port type semiconductor memory according to claim 1 wherein the first column decoders (CD$_1$) are connected to a common first column address bus (A$_1$).

3. A dual port type semiconductor memory according to any of the preceding claims, wherein the second column decoders (CD$_2$) are connected to a common second column address bus (A$_2$).

4. A dual port type semiconductor memory according to any of the preceding claims, wherein each memory cell (MC') comprises a single transistor.

## Revendications

1. Mémoire à semiconducteur incluant une mémoire à accès sélectif (RAM) du type dynamique comprenant une pluralité de fils de mot (W$_1$,W$_2$,...,W$_n$); une pluralité de paires de fils de bit (BL,$\overline{BL}$); une pluralité de cellules de mémoire dynamique (MC'), chaque cellule étant connectée entre des fils de mot et des fils de bit respectifs à chaque intersection des fils de mot et des paires de fils de bit,respectivement; une pluralité de premiers décodeurs de colonne (CD$_1$) connectés chacun à un bus d'écriture-lecture commun (B$_1$), et à une paire respective de fils de bit, dans laquelle chacun des premiers décodeurs de colonne (CD$_1$) est connecté au bus d'écriture-lecture (B$_1$) par l'intermédiaire d'une paire de portes (G$_1$) comprenant deux transistors connectés aux fils de bit respectifs pour permettre le transfert de données soit des fils de bit au bus d'écriture-lecture (B$_1$), soit du bus d'écriture-lecture (B$_1$) aux fils de bit; et une pluralité d'amplificateurs de détection (SA) connectés chacun à une paire respective de fils de bit pour mémoriser temporairement une donnée dans une cellule de mémoire sélectionnée afin d'empêcher la destruction de la donnée pendant une opération de lecture; caractérisée en ce que cette mémoire est constituée d'une mémoire à double porte d'accès, la mémoire comprenant en outre une pluralité de seconds décodeurs de colonne (CD$_2$) connectés chacun à un bus de lecture commun (B$_2$), et à une paire respective de fils de bit, dans laquelle chacun des seconds décodeurs de colonne (CD$_2$) est connecté au bus de lecture (B$_2$) par l'intermédiaire d'une paire de portes (G$_2$) comprenant quatre transistors, les électrodes de grille de deux des quatre transistors étant connectées aux fils de bit et celles des deux autres des quatre transistors étant connectées au bus de lecture (B$_2$) pour ne permettre le transfert de données que des fils de bit au bus de lecture (B$_2$).

2. Mémoire à semiconducteur du type à double porte d'accès selon la revendication 1, dans laquelle les premiers décodeurs de colonne (CD₁) sont connectés à un premier bus d'adresse de colonne commun ($A_1$).

3. Mémoire à semiconducteur du type à double porte d'accès selon l'une quelconque des revendications 1 et 2, dans laquelle les seconds décodeurs de colonne ($CD_2$) sont connectés à un second bus d'adresse de colonne commun ($A_2$).

4. Mémoire à semiconducteur du type à double porte d'accès selon l'une quelconque des revendications 1 à 3, dans laquelle chaque cellule de mémoire (MC') comprend un seul transistor.

**Patentansprüche**

1. Ein Halbleiterspeicher, der einen Speicher dynamischen Typs mit wahlfreiem Zugriff (RAM) enthält, mit einer Vielzahl von Wortleitungen ($W_1$ ... $W_n$); einer Vielzahl von Paaren von Bitleitungen (BL, $\overline{BL}$); einer Vielzahl von dynamischen Speicherzellen (MC'), wobei jede Zelle zwischen entsprechenden Wortleitungen und Bitleitungen an jedem Schnittpunkt jeweils der Wortleitungen und der Paare von Bitleitungen angeschlossen ist; einer Vielzahl von ersten Spaltendekodern ($CD_1$), wovon jeder mit einem gemeinsamen Schreib-Auslese-Bus ($B_1$) und mit einem entsprechenden Paar von Bitleitungen verbunden ist, wobei jeder der ersten Spaltendekoder ($CD_1$) mit dem Schreib-Auslese-Bus ($B_1$) durch ein Gatterpaar ($G_1$), welches zwei Transistoren umfaßt, verbunden ist, die mit den entsprechenden Bitleitungen verbunden sind, um die Daten entweder von den Bitleitungen zu dem Schreib-Auslese-Bus ($B_1$) oder von dem Schreib-Auslese-Bus ($B_1$) zu den Bitleitungen übertragen zu können; und einer Vielzahl von Leseverstärkern (SA), wovon jeder mit einem entsprechenden Paar von Bitleitungen verbunden ist, um Daten in einer ausgewählten Speicherzelle temporär zu speichern, um eine Zerstörung der Daten während einer Leseoperation zu verhindern; dadurch gekennzeichnet, daß der Speicher einen Speicher mit Doppelzugriffseinrichtung umfaßt, wobei der Speicher ferner eine Vielzahl von zweiten Spaltendekodern ($CD_2$) umfaßt, wovon jeder mit einem gemeinsamen Auslese-Bus ($B_2$) und mit einem entsprechenden Paar von Bitleitungen verbunden ist, wobei jeder der zweiten Spaltendekoder ($CD_2$) mit dem Auslese-Bus ($B_2$) durch ein Gatterpaar ($G_2$), welches vier Transistoren umfaßt, verbunden ist, wobei die Gate-Elektroden von zwei der vier Transistoren mit den Bitleitungen verbunden sind, und die anderen zwei der vier Transistoren mit dem Auslese-Bus ($B_2$) verbunden sind, damit die Daten nur von den Bitleitungen zu dem Auslese-Bus ($B_2$) übertragen werden können.

2. Ein Halbleiterspeicher des Typs mit Doppelzugriffseinrichtung nach Anspruch 1, bei dem die ersten Spaltendekoder ($CD_1$) mit einem gemeinsamen ersten Spaltenadreßbus ($A_1$) verbunden sind.

3. Ein Halbleiterspeicher des Typs mit Doppelzugriffseinrichtung nach irgendeinem der vorhergehenden Ansprüche, bei dem die zweiten Spaltendekoder ($CD_2$) mit einem gemeinsamen zweiten Spaltenadreßbus ($A_2$) verbunden sind.

4. Ein Halbleiterspeicher des Typs mit Doppelzugriffseinrichtung nach irgendeinem der vorhergehenden Ansprüche, bei dem jede Speicherzelle (MC') einen einzelnen Transistor enthält.

# Fig. 1

# Fig. 2

Fig. 3

EP 0 107 340 B1